# EUROPÄISCHE PATENTANMELDUNG

(11) **EP 4 391 589 A1**
(43) Veröffentlichungstag der Anmeldung: **26.06.2024**
(21) Anmeldenummer: 23216673.6
(22) Anmeldetag: 14.12.2023
(51) Int. Cl.: H04R 17/00, H04R 19/00

(54) **MEMS-VORRICHTUNG MIT EINEM VERBINDUNGSELEMENT**

(30) Priorität: 23.12.2022 DE 102022134733
(71) Anmelder: USound GmbH, 8020 Graz (AT)
(72) Erfinder: RUSCONI CLERICI BELTRAMI, Andrea, 1130 Wien (AT); BOTTONI, Ferruccio, 8020 Graz (AT); Horváth, Samu Bence, 1020 Wien (AT)
(74) Vertreter: Canzler & Bergmeier Patentanwälte Partnerschaft mbB

(57) **Zusammenfassung**

Die Erfindung betrifft eine MEMS-Vorrichtung (1), insbesondere zur Schallerzeugung und/oder Schallerfassung, mit einer Membran (2), die entlang einer Hubachse (3) auslenkbar ist, und mit einer MEMS-Einheit (7), die zumindest einen Kragarm (8) zum Erzeugen und/oder Erfassen einer Hubbewegung der Membran (2), der entlang der Hubachse (3) von der Membran (2) beabstandet ist, so dass zwischen dem Kragarm (8) und der Membran (2) ein Hohlraum (9) ausgebildet ist, eine Hubstruktur (12), die in dem Hohlraum (9) angeordnet und mit der Membran (2) verbunden ist, und ein Verbindungselement (14), das den Kragarm (8) beweglich mit der Hubstruktur (12) verbindet, umfasst. Erfindungsgemäß verschmälert und/oder verbreitert sich das Verbindungselement (14) in Richtung der Hubstruktur (12) in zumindest einem Abschnitt und/oder weist zumindest eine Aussparung (24, 25) auf. Des Weiteren betrifft die Erfindung eine MEMS-Einheit für eine entsprechende MEMS-Vorrichtung sowie eine Elektronikvorrichtung mit einer entsprechenden MEMS-Vorrichtung.

## Beschreibung

Die vorliegende Erfindung betrifft eine MEMS-Vorrichtung, insbesondere zur Schallerzeugung und/oder Schallerfassung (vorzugsweise von Hörschall und/oder Ultraschall), mit einer Membran, die entlang einer Hubachse auslenkbar ist, und mit einer MEMS-Einheit. Die MEMS-Einheit umfasst zumindest einen, insbesondere piezoelektrischen, Kragarm zum Erzeugen und/oder Erfassen einer Hubbewegung der Membran, der entlang der Hubachse von der Membran beabstandet ist, so dass zwischen dem Kragarm und der Membran ein Hohlraum ausgebildet ist, eine Hubstruktur, die in dem Hohlraum angeordnet und mit der Membran verbunden ist, und ein Verbindungselement, das den Kragarm beweglich mit der Hubstruktur verbindet. Des Weiteren betrifft die vorliegende Erfindung eine MEMS-Einheit für eine entsprechende MEMS-Vorrichtung.

Aus der WO 2016/034665 A1 ist ein MEMS bekannt, der eine Membran, eine Hubstruktur, die mit der Membran gekoppelt ist, und zumindest zwei piezoelektrische Aktuatoren, die über eine Mehrzahl von voneinander beabstandeten Verbindungselementen mit einer Mehrzahl von voneinander beabstandeten Kontaktpunkten der Hubstruktur verbunden sind, aufweist. Die zumindest zwei piezoelektrischen Aktuatoren sind ausgebildet, um eine Hubbewegung der Hubstruktur hervorzurufen, um die Membran auszulenken. Des Weiteren ist jeder der zumindest zwei piezoelektrischen Aktuatoren über zumindest zwei voneinander beabstandete Verbindungselemente mit zumindest zwei voneinander beabstandeten Kontaktpunkten der Hubstruktur verbunden. Es hat sich gezeigt, dass die Verbindungselemente und die Kontaktpunkte aufgrund äußerer Krafteinwirkung beschädigungsanfällig sind.

Aufgabe der vorliegenden Erfindung ist es, die aus dem Stand der Technik bekannten Nachteile zu beseitigen, insbesondere eine MEMS-Vorrichtung und eine MEMS-Einheit zu schaffen, die aufgrund äußerer Krafteinwirkung weniger beschädigungsanfällig ist.

Die Aufgabe wird gelöst durch eine MEMS-Vorrichtung und eine MEMS-Einheit mit den Merkmalen der unabhängigen Patentansprüche.

Vorgeschlagen wird eine MEMS-Vorrichtung, insbesondere zur Schallerzeugung und/oder Schallerfassung, nämlich vorzugsweise von Hörschall und/oder Ultraschall. Bei der MEMS-Vorrichtung handelt es sich insbesondere um einen MEMS-Lautsprecher, ein MEMS-Mikrofon und/oder einen MEMS-Sensor. Die MEMS-Vorrichtung umfasst eine Membran, die entlang einer Hubachse auslenkbar ist. Des Weiteren umfasst die MEMS-Vorrichtung eine MEMS-Einheit. Die MEMS-Einheit umfasst zumindest einen, insbesondere piezoelektrischen, Kragarm zum Erzeugen und/oder Erfassen einer Hubbewegung der Membran. Der Kragarm ist entlang der Hubachse von der Membran beabstandet, so dass zwischen dem Kragarm und der Membran ein Hohlraum ausgebildet ist. Ferner umfasst die MEMS-Einheit eine Hubstruktur, die in dem Hohlraum angeordnet und mit der Membran verbunden ist. Die Hubstruktur schwingt demnach im bestimmungsgemäßen Gebrauch gemeinsam mit der Membran entlang der Hubachse. Darüber hinaus weist die MEMS-Einheit ein Verbindungselement auf, das den Kragarm beweglich mit der Hubstruktur verbindet.

Vorteilhaft ist es, wenn das Verbindungselement in Richtung der Hubstruktur in zumindest einem Abschnitt verschmälert und/oder in zumindest einem Abschnitt verbreitert ist. Durch eine entsprechende Verbreiterung des Verbindungselements können Abschnitte, die besonders hohen Belastungen ausgesetzt sind, verstärkt werden. Zusätzlich oder alternativ können Bereiche, die geringeren Belastungen ausgesetzt sind, verschmälert werden, um die Elastizität und/oder Flexibilität des Verbindungselements zu erhöhen.

Zusätzlich oder alternativ ist es vorteilhaft, wenn das Verbindungselement zumindest eine Aussparung aufweist. Hierdurch kann das Gewicht des Verbindungselements reduziert werden, wodurch wiederum die auf das Verbindungselement einwirkenden Kräfte reduziert werden. Des Weiteren kann in demjenigen Bereich des Verbindungselements, in dem eine Aussparung angeordnet ist, die Elastizität und/oder Flexibilität des Verbindungselements erhöht werden. Infolgedessen kann beispielsweise ein Abschnitt des Verbindungselements durch eine Verbreiterung robuster ausgebildet werden. Zugleich kann in diesem Bereich durch eine entsprechende Aussparung die notwendige Elastizität und/oder Flexibilität sichergestellt werden.

Vorteilhaft ist es, wenn der Kragarm über nur ein einziges Verbindungselement mit der Hubstruktur verbunden ist. Vorteilhafterweise kann das Verbindungselement hierdurch sehr robust ausgebildet werden, da im Wesentlichen der gesamte zur Verfügung stehende Bauraum für das eine Verbindungselement verwendet werden kann.

Die Hubstruktur kann einteilig oder mehrteilig ausgebildet sein. Im Falle einer mehrteiligen Hubstruktur können zumindest zwei Teile der Hubstruktur unmittelbar miteinander verbunden sein. Alternativ können die zumindest zwei Teile auch mittelbar über ein dazwischen angeordnetes zusätzliches Element miteinander verbunden sein. Hierbei kann es sich beispielsweise um die Membran, insbesondere um ein starres Versteifungselement der Membran, oder ein zusätzliches, sich zwischen zwei Teilen der Hubstruktur erstreckendes Koppelelement handeln. Die Verbindung zwischen den zumindest zwei Teilen der Hubstruktur kann starr oder beweglich ausgebildet sein.

Vorteilhaft ist es, wenn sich zwei gegenüberliegende Längsseiten des Verbindungselements und/oder eine Grundform des Verbindungselements in Richtung der Hubstruktur trapezförmig verjüngen.

Ebenso ist es vorteilhaft, wenn das Verbindungselement zumindest einen Auskragungsabschnitt aufweist, in dem das Verbindungselement zumindest eine Auskragung aufweist, die sich in Querrichtung des Verbindungselements zu einer der beiden Längsseiten des Verbindungselements hinerstreckt und/oder in Querrichtung des Verbindungselements nach außen vorsteht.

Vorteile bringt es mit sich, wenn die zumindest eine Auskragung lotrecht zu einer Längsachse des Verbindungselements ausgerichtet ist. Zusätzlich oder alternativ ist es vorteilhaft, wenn sich zwei gegenüberliegende Längsseiten der Auskragung parallel zu einer Querachse des Verbindungselements erstrecken.

Ferner ist es vorteilhaft, wenn ein freies Auskragungsende der zumindest einen Auskragung in Richtung der Hubstruktur abgeschrägt ist. Hierdurch verjüngt sich das Verbindungselement im Bereich des Auskragungsabschnitts in Richtung der Hubstruktur.

Vorteilhaft ist es zudem, wenn der Auskragungsabschnitt zwei gegenüberliegende Auskragungen aufweist, wobei sich vorzugsweise eine erste Auskragung zu einer ersten Längsseite des Verbindungselements und eine zweite Auskragung zu einer zweiten Längsseite des Verbindungselements hinerstreckt.

Auch ist es vorteilhaft, wenn das Verbindungselement zu seiner Längsmittelachse achssymmetrisch ist.

Vorteile bringt es zudem mit sich, wenn sich die zumindest eine Aussparung in Richtung der Hubachse vollständig durch das Verbindungselement hindurcherstreckt. Infolgedessen weist die Aussparung zwei gegenüberliegende Öffnungen auf, von denen eine auf einer Oberseite und die andere auf einer Unterseite des Verbindungselements liegt. Zusätzlich oder alternativ ist es vorteilhaft, wenn die zumindest eine Aussparung in ihrer Umfangsrichtung ringförmig geschlossen ist.

Ebenso ist es vorteilhaft, wenn die Aussparung als in Querrichtung des Verbindungselements verlaufender Querschlitz ausgebildet ist. Vorzugsweise ist der Querschlitz lotrecht zur Längsmittelachse des Verbindungselements angeordnet.

Ferner ist es vorteilhaft, wenn die zumindest eine Aussparung in dem zumindest einen Auskragungsabschnitt angeordnet ist, wobei sich die Aussparung vorzugsweise in die erste und/oder zweite Auskragung hineinerstreckt.

Vorteile bringt es mit sich, wenn das Verbindungselement mit dem Kragarm, insbesondere ausschließlich, in einem sich in Querrichtung des Kragarms erstreckenden, vorzugsweise einzigen, ersten Kontaktbereich verbunden ist. Bei der aus dem Stand der Technik bekannten Vorrichtung hat sich gezeigt, dass Kontaktpunkte sehr bruchanfällig bei höheren Belastungen sind. Kontaktbereiche, die sich über eine größere Breite erstrecken, weisen im Gegensatz dazu eine höhere Druckfestigkeit auf.

Vorteilhaft ist es zudem, wenn der Kragarm an einem Träger der MEMS-Einheit, insbesondere einem Trägersubstrat, gelagert ist und ein vom Träger abgewandtes freies Kragarmende aufweist.

Vorteilhaft ist es, wenn der erste Kontaktbereich am freien Kragarmende angeordnet ist und/oder in Querrichtung des Kragarms schmaler als das freie Kragarmende ist.

Ebenso bringt es Vorteile mit sich, wenn das Verbindungselement mit der Hubstruktur, insbesondere ausschließlich, in einem sich in Querrichtung des Kragarms erstreckenden, vorzugsweise einzigen, zweiten Kontaktbereich verbunden ist.

Vorteile bringt es zudem mit sich, wenn der zweite Kontaktbereich an einer Seitenwand der Hubstruktur angeordnet ist und/oder sich in Querrichtung des Kragarms vollständig über diese Seitenwand erstreckt.

Des Weiteren ist es vorteilhaft, wenn der erste Kontaktbereich in Querrichtung des Kragarms breiter als der zweite Kontaktbereich ist.

Vorteile bringt es zudem mit sich, wenn das Verbindungselement zumindest einen Überbrückungsabschnitt aufweist, der vorzugsweise den zumindest einen Auskragungsabschnitt mit dem ersten Kontaktbereich, dem zweiten Kontaktbereich oder einem benachbarten weiteren Auskragungsabschnitt verbindet.

Vorteile bringt es mit sich, wenn der zumindest eine Überbrückungsabschnitt in Querrichtung des Verbindungselements mittig angeordnet ist und/oder im Vergleich zum zumindest einen Auskragungsabschnitt eine geringere Breite aufweist.

Ebenso ist es vorteilhaft, wenn das Verbindungselement mehrere in Längsrichtung des Verbindungselements voneinander beabstandete Überbrückungsabschnitte aufweist. Diesbezüglich ist es ferner vorteilhaft, wenn die Überbrückungsabschnitte zueinander mit geringerem Abstand zur Hubstruktur eine geringere Breite aufweisen, wobei vorzugsweise ein kragarmseitiger Überbrückungsabschnitt in Querrichtung des Verbindungselements eine größere Breite aufweist als ein hubstrukturseitiger Überbrückungsabschnitt.

Vorteilhaft ist es zudem, wenn das Verbindungselement eine tannenbaumförmige Grundform aufweist.

Auch ist es vorteilhaft, wenn das Verbindungselement mehrere in Längsrichtung des Verbindungselements voneinander beabstandete Auskragungsabschnitte aufweist, von denen zumindest einer gemäß der vorangegangenen Beschreibung ausgebildet ist, wobei die genannten Merkmale einzeln oder in beliebiger Kombination vorhanden sein können.

Ebenso ist es vorteilhaft, wenn die Auskragungsabschnitte zueinander mit geringerem Abstand zur Hubstruktur eine geringere Breite aufweisen, wobei vorzugsweise ein kragarmseitiger Auskragungsabschnitt in Querrichtung des Verbindungselements eine größere Breite als ein hubstrukturseitiger Auskragungsabschnitt aufweist.

Vorteilhaft ist es, wenn die freien Auskragungsenden zumindest zweier in Längsrichtung des Verbindungselements benachbarter Auskragungsabschnitte zueinander fluchten.

Ferner ist es vorteilhaft, wenn das Verbindungselement, insbesondere im Überbrückungsabschnitt, zumindest einen seitlichen Einschnitt aufweist, der sich von einer der beiden Längsseiten des Verbindungselements in das Verbindungselement hineinerstreckt.

Ebenso bringt es Vorteile mit sich, wenn in dem ersten Kontaktbereich ein Auskragungsabschnitt oder ein Überbrückungsabschnitt des Verbindungselements mit dem freien Kragarmende verbunden ist. Zusätzlich oder alternativ ist es vorteilhaft, wenn in dem zweiten Kontaktbereich ein Auskragungsabschnitt oder ein Überbrückungsabschnitt des Verbindungselements mit der Hubstruktur verbunden ist.

Vorteilhaft ist es, wenn der Kragarm eine elastische Trägerschicht und/oder zumindest eine Piezoschicht aufweist.

Eine sehr kostengünstige Herstellung wird ermöglicht, wenn die Trägerschicht des Kragarms, das Verbindungselement und ein Hubstrukturbasis der Hubstruktur, insbesondere im Bereich einer von der Membran abgewandte Hubstrukturstirnseite, aus einer gemeinsamen, insbesondere monolithischen, Schicht ausgebildet sind.

Ferner ist es vorteilhaft, wenn der Kragarm eine sich in Richtung der Hubstruktur verjüngende Trapezform aufweist. Zusätzlich oder alternativ ist es vorteilhaft, wenn das Verbindungselement diese Trapezform in Richtung der Hubstruktur fortführt.

Vorteile bringt es mit sich, wenn die MEMS-Einheit mehrere Kragarme, insbesondere sechs, aufweist, die jeweils über ein, vorzugsweise einziges, Verbindungselement mit der Hubstruktur verbunden sind, wobei die Verbindungselemente vorzugsweise gemäß der vorangegangenen Beschreibung ausgebildet sind, wobei die genannten Merkmale einzeln oder in beliebiger Kombination vorhanden sein können.

Vorteilhaft ist es zudem, wenn sich das Verbindungselement in Richtung der Hubstruktur zumindest in einem Abschnitt verschmälert und/oder verbreitert und/oder dass das Verbindungselement zumindest eine Aussparung aufweist.

Vorgeschlagen wird eine MEMS-Einheit, insbesondere für eine MEMS-Vorrichtung gemäß der vorangegangenen Beschreibung, mit zumindest einem, insbesondere piezoelektrischen, Kragarm zum Erzeugen und/oder Erfassen einer Hubbewegung einer Membran, mit einer Hubstruktur, die im bestimmungsgemäßen Gebrauch mit der Membran verbunden ist, und mit einem Verbindungselement, das den Kragarm beweglich mit der Hubstruktur verbindet. Vorteilhaft ist es, wenn sich das Verbindungselement in Richtung der Hubstruktur zumindest in einem Abschnitt verschmälert und/oder verbreitert. Zusätzlich oder alternativ ist es vorteilhaft, wenn das Verbindungselement zumindest eine Aussparung aufweist.

Vorteilhaft ist es, wenn die MEMS-Einheit gemäß der MEMS-Einheit der vorstehend beschriebenen MEMS-Vorrichtung ausgebildet ist, wobei die genannten Merkmale einzeln oder in beliebiger Kombination vorhanden sein können.

Vorgeschlagen wird die Verwendung einer MEMS-Einheit gemäß der vorangegangenen Beschreibung in einer MEMS-Vorrichtung gemäß der vorangegangenen Beschreibung, wobei die genannten Merkmale einzeln oder beliebiger Kombination vorhanden sein können.

Vorgeschlagen wird eine Elektronikvorrichtung, insbesondere ein Kopfhörer, eine Brille, ein Handy, ein Tablet und/oder ein Wearable, mit einer MEMS-Vorrichtung gemäß der vorangegangenen Beschreibung, wobei die genannten Merkmale einzeln oder in beliebiger Kombination vorhanden sein können.

Weitere Vorteile der Erfindung sind in den nachfolgenden Ausführungsbeispielen beschrieben. Es zeigen:
- **Figur 1**: eine Querschnittsansicht einer MEMS-Vorrichtung mit einer MEMS-Einheit,
- **Figur 2**: eine Draufsicht der MEMS-Einheit der in Figur 1 gezeigten MEMS-Vorrichtung,
- **Figur 3**: eine freigeschnittene Detailansicht eines einzelnen Kragarms mit Verbindungselement und Hubstruktur der in Figur 2 dargestellten MEMS-Einheit und
- **Figur 4**: eine nicht-freigeschnittene Detailansicht der in Figur 2 dargestellten MEMS-Einheit im Bereich der Hubstruktur und der Verbindungselemente.

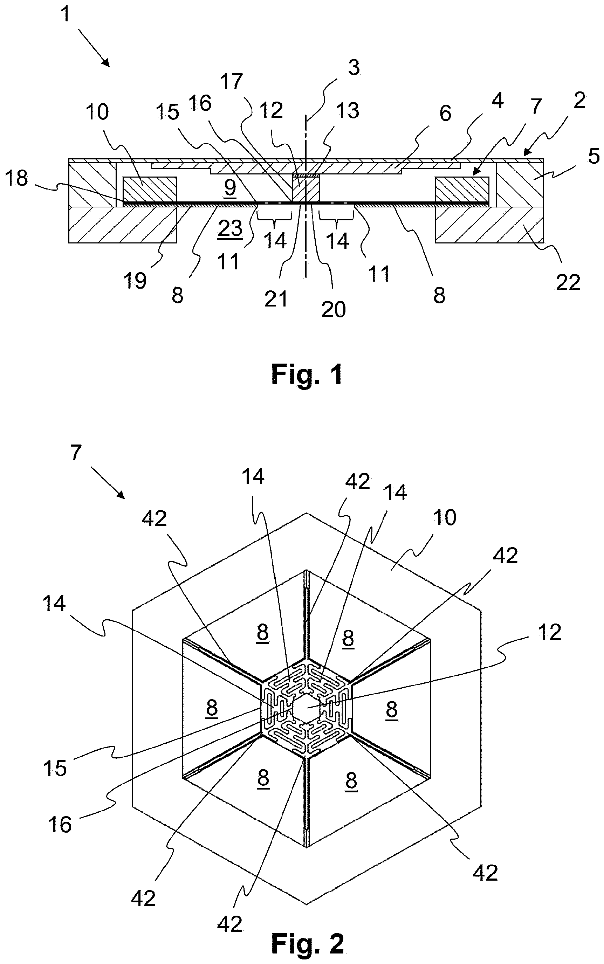

In den Figuren 1 - 4 ist ein Ausführungsbeispiel der Erfindung mit mehreren Kragarmen 8 gezeigt. Alternativ kann die Vorrichtung aber auch nur einen Kragarm 8 aufweisen, wobei die nachfolgende Beschreibung analog zu lesen ist.

Figur 1 zeigt eine Querschnittsansicht einer MEMS-Vorrichtung 1, insbesondere zur Schallerzeugung und/oder Schallerfassung. Hierbei kann die MEMS-Vorrichtung 1 insbesondere Hörschall und/oder Ultraschall erzeugen und/oder Erfassen. Bei der MEMS-Vorrichtung 1 handelt es sich vorzugsweise um einen MEMS-Lautsprecher, ein MEMS-Mikrofon und/oder einen MEMS-Sensor. Die MEMS-Vorrichtung 1 ist für eine nicht dargestellte Elektronikvorrichtung vorgesehen. Die Elektronikvorrichtung kann vorzugsweise derart ausgebildet sein, dass sie am Kopf oder am Körper getragen werden kann. Insbesondere ist die Elektronikvorrichtung ein Kopfhörer, eine Brille, ein Helm, ein Stirnband, ein Handy, ein Tablet, eine Uhr oder ein Armband. Alternativ kann die Elektronikvorrichtung aber auch derart ausgebildet sein, dass diese wiederum in anderen Vorrichtungen, wie beispielsweise einem Fahrzeug eingebaut werden kann.

Gemäß Figur 1 umfasst die MEMS-Vorrichtung 1 eine Membran 2, die entlang einer Hubachse 3 ausgelenkt werden kann. Die Membran 2 umfasst eine elastische Membranschicht 4, die in ihrem Randbereich an einem Membranträger 5 befestigt ist. Des Weiteren weist die Membran 2 ein starres Versteifungselement 6 auf, das mit dem Membranträger 5 mittelbar über die Membranschicht 4 verbunden ist.

Des Weiteren umfasst die MEMS-Vorrichtung 1 gemäß Figur 1 eine MEMS-Einheit 7. Diese weist zumindest einen, insbesondere piezoelektrischen, Kragarm 8 auf, mit dem eine Hubbewegung der Membran 2 entlang der Hubachse 3 erzeugt und/oder erfasst werden kann. Unter dem Begriff "Kragarm" ist ein einseitig gelagertes, biegsames Element zu verstehen, das ein auslenkbares freies Ende aufweist. Ferner umfasst die MEMS-Einheit 7 einen Träger 10, insbesondere ein Trägersubstrat, an dem der zumindest eine Kragarm 8 gelagert ist. Infolgedessen weißt der Kragarm 8 ein vom Träger 10 abgewandtes freies Kragarmende 11 auf, das entlang der Hubachse 3 ausgelenkt werden kann.

Der zumindest eine Kragarm 8 ist entlang der Hubachse 3 von der Membran 2 beabstandet, so dass zwischen dem Kragarm 8 und der Membran 2 ein Hohlraum 9 ausgebildet ist. Vorliegend ist der Hohlraum 9 zumindest teilweise in dem Träger 10 ausgebildet bzw. von diesem begrenzt.

Wie aus Figur 1 hervorgeht, umfasst die MEMS-Einheit 7 außerdem eine Hubstruktur 12, die zumindest teilweise in dem Hohlraum 9 angeordnet ist. Die Hubstruktur 12 ist mit der Membran 2 verbunden. Gemäß dem vorliegenden Ausführungsbeispiel ist die Hubstruktur 12 hierfür mit dem Versteifungselement 6 der Membran 2 über einen Kleber 13 verklebt. Die Hubstruktur 12 und der Träger 10 sind herstellungsbedingt vorzugsweise aus dem gleichen Material, nämlich insbesondere Silizium, ausgebildet. Die Hubstruktur 12 kann einteilig oder mehrteilig ausgebildet sein. Im Falle einer mehrteiligen Hubstruktur 12 können zumindest zwei Teile der Hubstruktur 12 unmittelbar miteinander verbunden sein. Alternativ können die zumindest zwei Teile auch mittelbar über ein dazwischen angeordnetes zusätzliches Element miteinander verbunden sein. Hierbei kann es sich beispielsweise um die Membran 2, insbesondere um das starre Versteifungselement 6 der Membran 2, oder ein zusätzliches, sich zwischen zwei Teilen der Hubstruktur 12 erstreckendes, nicht dargestelltes Koppelelement handeln. Die Verbindung zwischen den zumindest zwei Teilen der Hubstruktur 12 kann starr oder beweglich ausgebildet sein.

Der zumindest eine Kragarm 8 ist mit der Hubstruktur 12 mittelbar über ein Verbindungselement 14 beweglich verbunden. Die Ausgestaltung dieses Verbindungselements 14 ist in den nachfolgenden Figuren 2, 3 und 4 im Detail dargestellt und beschrieben. Im bestimmungsgemäßen Gebrauch wird das freie Kragarmende 11 in Richtung der Hubachse 3 ausgelenkt. Um bei dieser gekrümmten Auslenkung des Kragarmendes 11 ein Verkippen der Hubstruktur 12 und/oder der Membran 2 zu vermeiden, ist der Kragarm 8 im Bereich seines freien Kragarmendes 11 mittelbar über das Verbindungselement 14 mit der Hubstruktur 12 verbunden. Das Verbindungselement 14 ist hierfür elastisch und/oder flexibel ausgebildet.

Das Kragarmende 11 des Kragarms 8 ist mit dem Verbindungselement 14 in einem ersten Kontaktbereich 15 verbunden. Des Weiteren ist die Hubstruktur 12 in einem zweiten Kontaktbereich 16 mit dem Verbindungselement 14 verbunden. Wie insbesondere aus Figur 1 hervorgeht, ist das Verbindungselement 14 an einer Seitenwand 17 der Hubstruktur 12 verbunden.

Der Kragarm 8 ist als mehrschichtige Struktur ausgebildet. Er umfasst eine elastische Trägerschicht 18. Des Weiteren weist der Kragarm 8 eine Piezoschicht 19 auf. Die Piezoschicht 19 ist zwischen zwei vorliegend nicht dargestellten Elektronenschichten angeordnet. Die Piezoschicht 19 kann sich wie in Figur 1 dargestellt unterhalb der Trägerschicht 18 befinden. Alternativ kann diese aber auch abbildungsgemäß auf der Trägerschicht 18 angeordnet sein.

In dem vorliegenden Ausführungsbeispiel umfasst die MEMS-Einheit 7 mehrere Kragarme 8, die jeweils über ein einziges jeweiliges Verbindungselement 14 mit der Hubstruktur 12 verbunden sind. Aus Gründen der Übersichtlichkeit ist nur einer dieser Kragarme 8 mit seinem korrespondierenden Verbindungselement 14 vollständig mit Bezugszeichen versehen. Um eine kostengünstige und schnelle Herstellung gewährleisten zu können, ist es vorteilhaft, wenn die Trägerschicht 18 der Kragarme 8, die Verbindungselemente 14 und eine Hubstrukturbasis 20 der Hubstruktur 12 aus einer gemeinsamen, insbesondere monolithischen, Schicht ausgebildet sind. Die Hubstrukturbasis 20 ist hierbei vorzugsweise im Bereich einer der Membran 2 abgewandten Hubstrukturstirnseite 21 angeordnet.

Die MEMS-Vorrichtung 1 umfasst gemäß Figur 1 des Weiteren eine Leiterplatte 22, an der die MEMS-Einheit 7 angeordnet ist. Die Leiterplatte 22 weist einen Leiterplattenhohlraum 23 auf, der sich an den Hohlraum 9 der MEMS-Einheit 7 anschließt. Infolgedessen bilden der Hohlraum 9 der MEMS-Einheit 7 und der Leiterplattenhohlraum 23 eine gemeinsame akustische Kavität der MEMS-Vorrichtung 1 aus. Die Kragarme 8 und die Hubstruktur 12 können sich entlang der Hubachse 3 in den Leiterplattenhohlraum 23 hineinbewegen. Neben der MEMS-Einheit 7 ist auch der Membranträger 5 an der Leiterplatte 22 befestigt.

Figur 2 zeigt eine Draufsicht der MEMS-Einheit 7. In dieser ist zu erkennen, dass der Träger 10 als geschlossener und/oder mehreckiger Ring ausgebildet ist. Die Kragarme 8 sind in Umfangsrichtung verteilt an dem Träger 10 angeordnet und erstrecken sich radial nach innen. Zentral mittig ist die Hubstruktur 12 angeordnet. Die Hubstruktur 12 weist eine zum Träger 10 korrespondierende, nämlich vorliegend mehreckige, Form auf. Infolgedessen weißt die Hubstruktur 12 mehrere Seitenwände 17 auf, die jeweils einem der Kragarme 8 zugeordnet sind. Die Kragarme 8 weisen eine sich in Richtung der Hubstruktur 12 verjüngende Trapezform auf. Diese Trapezform wird von dem jeweils zugeordneten Verbindungselement 14 in Richtung der Hubstruktur 12 fortgeführt, so dass auch die Verbindungselemente 14 eine trapezförmige Grundform aufweisen.

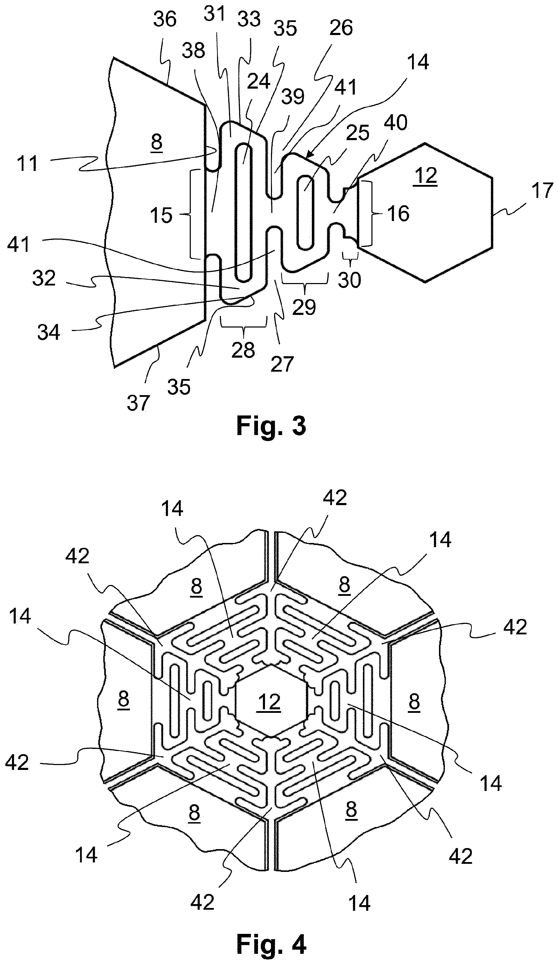

Figur 3 zeigt eine freigeschnittene Detailansicht der in Figur 2 dargestellten MEMS-Einheit 7 der MEMS-Vorrichtung 1 im Bereich eines Kragarmendes 11 eines der Kragarme 8. Ein mit nur einem einzigen Kragarm 8 ausgebildetes Ausführungsbeispiel könnte analog ausgebildet sein. Wie bereits vorstehend erwähnt, ist das freie Kragarmende 11 des jeweiligen Kragarms 8 über ein jeweiliges Verbindungselement 14 mit der Hubstruktur 12 beweglich verbunden. Wie aus Figur 3 hervorgeht, ist der Kragarm 8 über nur ein einziges Verbindungselement 14 mit der Hubstruktur 12 verbunden. Vorteilhafterweise kann somit der zur Verfügung stehende Bauraum für dieses einzige Verbindungselement 14 bestmöglich ausgenutzt werden.

Das Verbindungselement 14 verschmälert sich gemäß der in Figur 3 dargestellten Draufsicht in Richtung der Hubstruktur 12 in zumindest einem Abschnitt. Des Weiteren verbreitert sich das Verbindungselement 14 in zumindest einem Abschnitt. Durch eine entsprechende Verbreiterung des Verbindungselements 14 können Abschnitte, die besonders hohen Belastungen ausgesetzt sind, verstärkt werden. Zusätzlich können Abschnitte, die geringeren Belastungen ausgesetzt sind, verschmälert werden, um die Elastizität und/oder Flexibilität des Verbindungselements 14 zu erhöhen.

Des Weiteren weist das Verbindungselement 14 zumindest eine Aussparung 24, 25 auf. Hierdurch kann das Gewicht des Verbindungselements 14 reduziert werden, wodurch wiederum die auf das Verbindungselement 14 einwirkenden Kräfte reduziert werden. Des Weiteren kann in demjenigen Bereich des Verbindungselements 14, in dem eine Aussparung 24, 25 angeordnet ist, die Elastizität und/oder Flexibilität des Verbindungselements 14 erhöht werden. Infolgedessen kann beispielsweise ein Abschnitt des Verbindungselements 14 durch eine Verbreiterung robuster ausgebildet werden. Zugleich kann in diesem Bereich durch eine entsprechende Aussparung 24, 25 die notwendige Elastizität und/oder Flexibilität sichergestellt werden.

Die zumindest eine Aussparung 24, 25 erstreckt sich in Richtung der Hubachse 3 vollständig durch das Verbindungselement 14 hindurch. Infolgedessen weist die Aussparung 24, 25 zwei Öffnungen auf, die an zwei gegenüberliegenden Seiten des Verbindungselements 14 angeordnet sind. Des Weiteren ist die zumindest eine Aussparung 24, 25 in ihrer Längsrichtung ringförmig geschlossen. Hierdurch kann eine sehr hohe Stabilität sichergestellt werden. Gemäß dem vorliegenden Ausführungsbeispiel sind die Aussparungen 24, 25 als in Querrichtung des Verbindungselements 14 verlaufender Querschlitze ausgebildet.

Gemäß der in Figur 3 dargestellten Draufsicht verjüngen sich zwei gegenüberliegende Längsseiten 26, 27 des Verbindungselements 14 in Richtung der Hubstruktur 12. Das Verbindungselement 14 ist mit dem Kragarm 8 ausschließlich in dem einzigen ersten Kontaktbereich 15 verbunden. Hierbei ist der erste Kontaktbereich 15 am freien Kragarmende 11 angeordnet. Wie aus Figur 3 hervorgeht, ist der erste Kontaktbereich 15 in Querrichtung des Kragarms 8 schmaler als das freie Kragarmende 11.

Mit der Hubstruktur 12 ist das Verbindungselement 14 gemäß Figur 3 ausschließlich in dem einzigen zweiten Kontaktbereich 16 verbunden. Der zweite Kontaktbereich 16 erstreckt sich in Querrichtung des Kragarms 8. Der zweite Kontaktbereich 16 ist, wie bereits vorstehend erwähnt, an einer der Seitenwände 17 der Hubstruktur 12 ausgebildet. Um eine möglichst robuste Verbindung sicherstellen zu können, erstreckt sich der zweite Kontaktbereich 16, wie in Figur 3 dargestellt, über mehr als die halbe Breite der korrespondierenden Seitenwand 17 der Hubstruktur 12. Der erste Kontaktbereich 15 ist in Querrichtung des Kragarms 8 breiter als der zweite Kontaktbereich 16 ausgebildet.

Gemäß Figur 3 weist das Verbindungselement 14 zumindest einen Auskragungsabschnitt 28, 29, 30 auf, wobei das Verbindungselement 14 in dem vorliegenden Ausführungsbeispiel drei Auskragungsabschnitte 28, 29, 30 aufweist. In diesem zumindest einen Auskragungsabschnitt 28, 29, 30 weist das Verbindungselement 14 zumindest eine Auskragung 31, 32 auf. Die zumindest eine Auskragung 31, 32 erstreckt sich in Querrichtung des Verbindungselements 14 zu einer der beiden Längsseiten 26, 27 des Verbindungselements 14 hin. Infolgedessen steht die zumindest eine Auskragung 31, 32 in Querrichtung des Verbindungselements 14 nach außen vor. Die zumindest eine Auskragung 31, 32 ist lotrecht zu einer Längsachse des Verbindungselements 14 ausgerichtet. Gemäß der in Figur 3 dargestellten Draufsicht weist die Auskragung 31, 32 zwei gegenüberliegende Längsseiten 33, 34 auf. Die beiden Längsseiten 33, 34 der zumindest einen Auskragung 31, 32 sind parallel zueinander ausgerichtet und/oder erstrecken sich parallel zu einer Querachse des Verbindungselements 14. Die zumindest eine Auskragung 31, 32 weist ein freies Auskragungsende 35 auf. Das freie Auskragungsende 35 der zumindest einen Auskragung 31, 32 ist abgeschrägt. Die Abschrägung ist hierbei derart ausgebildet, dass sich das Verbindungselement 14 in Richtung der Hubstruktur 12 verjüngt. Des Weiteren fluchtet diese mit einer Längsseite 36, 37 des Kragarms 8.

In dem vorliegenden Ausführungsbeispiel weist der zumindest eine Auskragungsabschnitt 28, 29, 30 zwei gegenüberliegende Auskragungen 31, 32 auf. Hierbei erstreckt sich die erste Auskragung 31 in Querrichtung zur ersten Längsseite 26 des Verbindungselements 14. Die zweite Auskragung 32 ist zu der ersten Auskragung 31 entgegengesetzt orientiert. Demnach erstreckt sich die zweite Auskragung 32 zu der zweiten Längsseite 27 des Verbindungselements 14.

Die zumindest eine Aussparung 24, 25 ist, wie insbesondere in Figur 3 zu sehen ist, in dem zumindest einen Auskragungsabschnitt 28, 29 angeordnet. Die dem Auskragungsabschnitt 28, 29 zugeordnete Aussparung 24, 25 erstreckt sich hierbei in die erste und zweite Auskragung 31, 32 des Auskragungsabschnitts 28, 29 hinein. Vorteilhafterweise ist zumindest einer der Auskragungsabschnitte 28, 29 als geschlossener Ring ausgebildet.

In dem in Figur 3 dargestellten Ausführungsbeispiel umfasst das Verbindungselement 14 einen ersten und einen zweiten Auskragungsabschnitt 28, 29, die gemäß der vorstehenden Beschreibung ausgebildet sind. Demnach weist der erste Auskragungsabschnitt 28 und der zweite Auskragungsabschnitt 29 jeweils zwei gegenüberliegende Auskragungen 31, 32 auf. Darüber hinaus weist der erste Auskragungsabschnitt 28 eine erste Aussparung 24 und der zweite Auskragungsabschnitt 29 eine zweite Aussparung 25 auf. Der kragarmseitige erste Auskragungsabschnitt 28 weist im Vergleich zu dem hubstrukturseitigen zweiten Auskragungsabschnitt 29 in Querrichtung eine größere Breite auf. Infolgedessen weisen die Auskragungsabschnitte 28, 29, 30 mit zunehmender Entfernung vom freien Kragarmende 11 eine geringere Breite auf. Wie aus Figur 3 auch hervorgeht, fluchten die freien Auskragungsenden 35 des ersten und zweiten Auskragungsabschnitts 28, 29 zueinander. Darüber hinaus fluchten diese auch mit der jeweils zugeordneten Längsseite 36, 37 des Kragarms 8. Infolgedessen weisen die beiden Auskragungsabschnitte 28, 29 des Verbindungselements 14 zusammen mit den Längsseiten 36, 37 des Kragarms 8 eine trapezförmige Grundform auf, die sich in Richtung der Hubstruktur 12 verjüngt.

Des Weiteren weist das Verbindungselement 14 gemäß dem in Figur 3 dargestellten Ausführungsbeispiel einen dritten Auskragungsabschnitt 30 auf. Auch dieser dritte Auskragungsabschnitt 30 umfasst zwei Auskragungen 31, 32, die sich jeweils zu einer der beiden Längsseiten 26, 27 des Verbindungselements 14 hinerstrecken. Im Gegensatz zum ersten und zweiten Auskragungsabschnitt 28, 29 verbreitert sich dieser jedoch in Richtung der Hubstruktur 12. Da vorliegend der zweite Kontaktbereich 16 zwischen dem dritten Auskragungsabschnitt 30 und der Hubstruktur 12 ausgebildet ist, kann hierdurch eine sehr große Breite des zweiten Kontaktbereichs 16 erzielt werden. Ein weiterer Unterschied zwischen dem zur Hubstruktur 12 benachbarten dritten Auskragungsabschnitt 30 und den anderen Auskragungsabschnitte 28, 29 besteht darin, dass der dritte Auskragungsabschnitt 30 keine Aussparung aufweist, sondern stattdessen vollflächig geschlossen ist. Auch hierdurch kann wiederum die Stabilität des unmittelbar zur Hubstruktur 12 benachbarten dritten Auskragungsabschnitt 30 erhöht werden.

Gemäß Figur 3 weist das Verbindungselement 14 zumindest einen Überbrückungsabschnitt 38, 39, 40 auf. Dieser zumindest eine Überbrückungsabschnitt 38, 39, 40 verbindet einen der Auskragungsabschnitte 28, 29, 30 mit dem kragarmseitigen ersten Kontaktbereich 15 oder mit einem in Längsrichtung benachbarten Auskragungsabschnitt 28, 29, 30. Der zumindest eine Überbrückungsabschnitt 38, 39, 40 ist in Querrichtung des Verbindungselements 14 mittig angeordnet. Des Weiteren weist dieser im Vergleich zu dem zumindest einen benachbarten Auskragungsabschnitt 28, 29, 30 eine geringere Breite auf. Der zumindest eine Überbrückungsabschnitt 38, 39, 40 weist vorzugsweise konkav gekrümmte Längsseiten auf.

In dem in Figur 3 dargestellten Ausführungsbeispiel weist das Verbindungselement 14 seitliche Einschnitte 41 auf. Diese erstrecken sich von einer der beiden Längsseiten 26, 27 des Verbindungselements 14 in das Verbindungselement 14 hinein. Die Einschnitte 41 sind in Längsrichtung des Verbindungselements 14 im Bereich der Überbrückungsabschnitte 38, 39, 40 angeordnet. Demnach weisen die Überbrückungsabschnitte 38, 39, 40 an ihren beiden Längsseiten jeweils einen benachbarten Einschnitt 41 auf.

In dem vorliegenden Ausführungsbeispiel umfasst das Verbindungselement 14 einen ersten Überbrückungsabschnitt 38 der in Längsrichtung des Verbindungselements 14 zwischen dem freien Kragarmende 11 und dem ersten Auskragungsabschnitt 28 angeordnet ist. Über den ersten Überbrückungsabschnitt 38 ist das Verbindungselement 14 somit mit dem freien Kragarmende 11 verbunden. Infolgedessen ist der erste Kontaktbereich 15 zwischen dem freien Kragarmende 11 und dem ersten Überbrückungsabschnitt 38 ausgebildet. Der erste Überbrückungsabschnitt 38 weist hierbei im Vergleich zum freien Kragarmende 11 in Querrichtung des Verbindungselements 14 eine geringere Breite auf.

Zwischen dem ersten und zweiten Auskragungsabschnitt 28, 29 ist ein zweiter Überbrückungsabschnitt 39 ausgebildet. Infolgedessen ist der erste und zweite Auskragungsabschnitt 28, 29 in Längsrichtung des Verbindungselements 14 voneinander beabstandet und über den zweiten Überbrückungsabschnitt 39 miteinander verbunden. Der zur Hubstruktur 12 nähere zweite Überbrückungsabschnitt 39 weist im Vergleich zu dem ersten Überbrückungsabschnitt 38 in Querrichtung des Verbindungselements 14 eine geringere Breite auf. Darüber hinaus weist das Verbindungselement 14 einen dritten Überbrückungsabschnitt 40 auf. Dieser ist in Längsrichtung des Verbindungselements 14 zwischen dem zweiten Auskragungsabschnitt 29 und dem dritten Auskragungsabschnitt 30 angeordnet. Infolgedessen ist auch der zweite Auskragungsabschnitt 29 in Längsrichtung des Verbindungselements 14 von dem dritten Auskragungsabschnitt 30 beabstandet und über den dritten Überbrückungsabschnitt 40 mit diesem verbunden. Der dritte Überbrückungsabschnitt 40 weist im Vergleich zu dem zweiten Überbrückungsabschnitt 39 in Querrichtung des Verbindungselements 14 eine geringere Breite auf. Mit zunehmender Entfernung vom freien Kragarmende 11 nimmt demnach die Breite der Überbrückungsabschnitte 38, 39, 40 ab.

Zusammenfassend ist somit festzustellen, dass die Breite des Verbindungselements 14 iterativ in den Überbrückungsabschnitten 38, 39, 40 abnimmt und in den Auskragungsabschnitten 28, 29, 30 zunimmt. Hierdurch weist das Verbindungselement 14 eine tannenbaumförmige Grundform auf, die sich vorzugsweise in Längsrichtung des Verbindungselements 14 in Richtung der Hubstruktur 12 verjüngt.

Figur 4 zeigt eine nicht-freigeschnittene Detailansicht der in Figur 2 dargestellten MEMS-Einheit 7 im Bereich der Hubstruktur 12, die über ein jeweiliges Verbindungselement 14 mit den jeweiligen Kragarmen 8 verbunden ist. Aus der dargestellten Draufsicht wird ersichtlich, dass sich die Verbindungselemente 14 mit dem jeweils zugeordneten Kragarm 8 sternförmig von der zentralen Hubstruktur 12, die vorliegend als Sechseck ausgebildet ist, radial nach außen erstrecken. Jedem der Kragarme 8 ist jeweils nur ein einziges Verbindungselement 14 zugeordnet. Des Weiteren weist jedes Verbindungselement 14 nur einen einzigen ersten Kontaktbereich 15 zum zugeordneten Kragarm 8 auf. Ebenso weist jedes Verbindungselement 14 nur einen einzigen zweiten Kontaktbereich 16 zur Hubstruktur 12 auf. Die Verbindungselemente 14 und die Kragarme 8 sind von den jeweils benachbarten Verbindungselementen 14 und benachbarten Kragarmen 8 über einen Schlitz 42 beabstandet, so dass zwischen diesen keine Verbindung vorliegt.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: MEMS-Vorrichtung
- 2: Membran
- 3: Hubachse
- 4: Membranschicht
- 5: Membranträger
- 6: Versteifungselement
- 7: MEMS-Einheit
- 8: Kragarm
- 9: Hohlraum
- 10: Träger
- 11: freies Kragarmende
- 12: Hubstruktur
- 13: Kleber
- 14: Verbindungselement
- 15: ersten Kontaktbereich
- 16: zweiten Kontaktbereich
- 17: Seitenwand der Hubstruktur
- 18: Trägerschicht
- 19: Piezoschicht
- 20: Hubstrukturbasis
- 21: Hubstrukturstirnseite
- 22: Leiterplatte
- 23: Leiterplattenhohlraum
- 24: erste Aussparung
- 25: zweite Aussparung
- 26: erste Längsseiten des Verbindungselements
- 27: zweite Längsseiten des Verbindungselements
- 28: erster Auskragungsabschnitt
- 29: zweiter Auskragungsabschnitt
- 30: dritter Auskragungsabschnitt
- 31: erste Auskragung
- 32: zweite Auskragung
- 33: erste Längsseite der Auskragung
- 34: zweite Längsseite der Auskragung
- 35: Auskragungsende
- 36: erste Längsseite des Kragarms
- 37: zweite Längsseite des Kragarms
- 38: erster Überbrückungsabschnitt
- 39: zweiter Überbrückungsabschnitt
- 40: dritter Überbrückungsabschnitt
- 41: Einschnitt
- 42: Schlitz

## Patentansprüche

1. MEMS-Vorrichtung (1), insbesondere zur Schallerzeugung und/oder Schallerfassung,
mit einer Membran (2), die entlang einer Hubachse (3) auslenkbar ist, und
mit einer MEMS-Einheit (7), die
zumindest einen Kragarm (8) zum Erzeugen und/oder Erfassen einer Hubbewegung der Membran (2), der entlang der Hubachse (3) von der Membran (2) beabstandet ist, so dass zwischen dem Kragarm (8) und der Membran (2) ein Hohlraum (9) ausgebildet ist,
eine Hubstruktur (12), die in dem Hohlraum (9) angeordnet und mit der Membran (2) verbunden ist, und
ein Verbindungselement (14), das den Kragarm (8) beweglich mit der Hubstruktur (12) verbindet, umfasst,
**dadurch gekennzeichnet,**
**dass** sich das Verbindungselement (14) in Richtung der Hubstruktur (12) in zumindest einem Abschnitt verschmälert und/oder in zumindest einem Abschnitt verbreitert und/oder
**dass** das Verbindungselement (14) zumindest eine Aussparung (24, 25) aufweist.

2. MEMS-Vorrichtung nach dem vorangegangenen Anspruch, **dadurch gekennzeichnet, dass** der Kragarm (8) über nur ein einziges Verbindungselement (14) mit der Hubstruktur (12) verbunden ist.

3. MEMS-Vorrichtung nach einem der vorangegangenen Ansprüche, **dadurch gekennzeichnet, dass** sich zwei gegenüberliegende Längsseiten (26, 27) des Verbindungselements (14) und/oder eine Grundform des Verbindungselements (14) in Richtung der Hubstruktur (12) trapezförmig verjüngen.

4. MEMS-Vorrichtung nach einem der vorangegangenen Ansprüche, **dadurch gekennzeichnet, dass** das Verbindungselement (14) zumindest einen Auskragungsabschnitt (28, 29, 30) aufweist, in dem das Verbindungselement (14) zumindest eine Auskragung (31, 32) aufweist, die sich in Querrichtung des Verbindungselements (14) zu einer der beiden Längsseite (26, 27) des Verbindungselements (14) hinerstreckt; wobei der Auskragungsabschnitt (28, 29, 30) vorzugsweise zwei gegenüberliegende Auskragungen (31, 32) aufweist, wobei sich vorzugsweise eine erste Auskragung (31) zu einer ersten Längsseite (26) des Verbindungselements (14) und eine zweite Auskragung (32) zu einer zweiten Längsseite (27) des Verbindungselements (14) hinerstreckt.

5. MEMS-Vorrichtung nach einem der vorangegangenen Ansprüche,
**dadurch gekennzeichnet, dass** sich die zumindest eine Aussparung (24, 25) in Richtung der Hubachse (3) vollständig durch das Verbindungselement (14) hindurcherstreckt,
dass die zumindest eine Aussparung (24, 25) in ihrer Umfangsrichtung ringförmig geschlossen ist und/oder
dass die zumindest eine Aussparung (24, 25) in dem zumindest einen Auskragungsabschnitt (28, 29) angeordnet ist und sich vorzugsweise in die erste und/oder zweite Auskragung (31, 32) hineinerstreckt.

6. MEMS-Vorrichtung nach einem der vorangegangenen Ansprüche, **dadurch gekennzeichnet, dass** das Verbindungselement (14) mit dem Kragarm (8), insbesondere ausschließlich, in einem sich in Querrichtung des Kragarms (8) erstreckenden, vorzugsweise einzigen, ersten Kontaktbereich (15) verbunden ist und/oder dass der Kragarm (8) ein von einem Träger (10) der MEMS-Einheit (7) abgewandtes freies Kragarmende (11) aufweist und dass der erste Kontaktbereich (15) am freien Kragarmende (11) angeordnet ist und/oder in Querrichtung des Kragarms (8) schmaler als das freie Kragarmende (11) ist.

7. MEMS-Vorrichtung nach einem der vorangegangenen Ansprüche, **dadurch gekennzeichnet, dass** das Verbindungselement (14) mit der Hubstruktur (12), insbesondere ausschließlich, in einem sich in Querrichtung des Kragarms (8) erstreckenden, vorzugsweise einzigen, zweiten Kontaktbereich (16) verbunden ist.

8. MEMS-Vorrichtung nach einem der vorangegangenen Ansprüche, **dadurch gekennzeichnet, dass** das Verbindungselement (14) zumindest einen Überbrückungsabschnitt (38, 39, 40) aufweist, der vorzugsweise den zumindest einen Auskragungsabschnitt (28, 29, 30) mit dem ersten Kontaktbereich (15), dem zweiten Kontaktbereich (16) oder einem benachbarten weiteren Auskragungsabschnitt (28, 29, 30) verbindet.

9. MEMS-Vorrichtung nach einem der vorangegangenen Ansprüche, **dadurch gekennzeichnet, dass** der zumindest eine Überbrückungsabschnitt (38, 39, 40) in Querrichtung des Verbindungselements (14) mittig angeordnet ist und/oder im Vergleich zum zumindest einen Auskragungsabschnitt (28, 29, 30) eine geringere Breite aufweist.

10. MEMS-Vorrichtung nach einem der vorangegangenen Ansprüche, **dadurch gekennzeichnet, dass** das Verbindungselement (14) mehrere in Längsrichtung des Verbindungselements (14) voneinander beabstandete Auskragungsabschnitte (28, 29, 30) aufweist, von denen zumindest einer gemäß einem oder mehreren der vorherigen Ansprüche ausgebildet ist und/oder
dass die Auskragungsabschnitte (28, 29, 30) zueinander mit geringerem Abstand zur Hubstruktur (12) eine geringere Breite aufweisen.

11. MEMS-Vorrichtung nach einem der vorangegangenen Ansprüche, **dadurch gekennzeichnet, dass** das Verbindungselement (14), insbesondere im Überbrückungsabschnitt (38, 39, 40), zumindest einen seitlichen Einschnitt (41) aufweist, der sich von einer der beiden Längsseiten (26, 27) des Verbindungselements (14) in das Verbindungselement (14) hineinerstreckt.

12. MEMS-Vorrichtung nach einem der vorangegangenen Ansprüche, **dadurch gekennzeichnet, dass** der Kragarm (8) eine sich in Richtung der Hubstruktur (12) verjüngende Trapezform aufweist und/oder dass das Verbindungselement (14) diese Trapezform in Richtung der Hubstruktur (12) fortführt.

13. MEMS-Vorrichtung nach einem der vorangegangenen Ansprüche, **dadurch gekennzeichnet, dass** die MEMS-Einheit (7) mehrere Kragarme (8), insbesondere sechs, aufweist, die jeweils über ein, vorzugsweise einziges, Verbindungselement (14) mit der Hubstruktur (12) verbunden sind, wobei zumindest eines der Verbindungselemente, insbesondere alle Verbindungselemente, vorzugsweise gemäß einem oder mehreren der vorherigen Ansprüche ausgebildet sind.

14. MEMS-Einheit (7), insbesondere für eine MEMS-Vorrichtung (1) gemäß einem der vorangegangenen Ansprüche,
mit zumindest einem Kragarm (8) zum Erzeugen und/oder Erfassen einer Hubbewegung einer Membran (2),
mit einer Hubstruktur (12), die im bestimmungsgemäßen Gebrauch mit der Membran (2) verbunden ist, und
mit einem Verbindungselement (14), das den Kragarm (8) beweglich mit der Hubstruktur (12) verbindet,
**dadurch gekennzeichnet,**
**dass** sich das Verbindungselement (14) in Richtung der Hubstruktur (12) zumindest in einem Abschnitt verschmälert und/oder verbreitert und/oder
**dass** das Verbindungselement (14) zumindest eine Aussparung (24, 25) aufweist.

15. Elektronikvorrichtung mit einer MEMS-Vorrichtung (1) gemäß einem oder mehreren der vorherigen Ansprüche.
